# EUROPEAN PATENT APPLICATION

(11) **EP 4 661 289 A1**
(43) Date of publication of application: **10.12.2025**
(21) Application number: 25178113.4
(22) Date of filing: 22.05.2025
(51) Int. Cl.: H03F 1/02, H03F 3/24, H03F 3/72, H03F 3/21, H03F 1/32, H03F 1/56, H03F 3/195

(54) **SELECTIVE ACTIVATION OF AMPLIFYING DEVICES OF A POWER AMPLIFICATION SYSTEM**

(30) Priority: 04.06.2024 FI 20245714
(71) Applicant: Nokia Solutions and Networks Oy, 02610 Espoo (FI)
(72) Inventor: WOLFF, Gunter, Laupheim (DE); GHOSE, Abhijit, Grapevine (US); JELONNEK, Björn, Ulm (DE); DECHEN, Frank, Neu Ulm (DE)
(74) Representative: Nokia EPO representatives

(57) **Abstract**

The present subject matter relates to a method for amplifying a radio frequency (RF) signal for a power amplification system comprising multiple amplifying devices, the method comprising: determining a configuration of the power amplification system based on power values related to the RF signal, wherein the configuration indicates an activation-deactivation pattern of the amplifying devices of the power amplification system for amplification of the RF signal, controlling the power amplification system according to the determined configuration for amplifying the RF signal.

## Description

### Technical Field

Various example embodiments relate to telecommunication systems, and more particularly to a selective activation of amplifying devices of a power amplification system.

### Background

In contemporary radio transmitter design, managing power consumption has become a paramount concern. A notable portion of the direct current (DC) power supplied to these systems may be lost as heat within the power amplifier (PA), a critical component responsible for amplifying the radio frequency (RF) signal to the necessary levels for transmission. The efficiency of this process, known as the PA's drain efficiency, may be defined by the ratio between an RF output power to a DC input power. It is observed that this efficiency tends to drop during periods of lower RF output power. This drop in efficiency during periods of lower RF output power may need to be mitigated.

### Summary

Example embodiments provide an apparatus for amplifying a radio frequency (RF) signal using a power amplification system comprising multiple amplifying devices, the apparatus comprising at least one processor; and at least one memory storing instructions that, when executed by the at least one processor, cause the apparatus at least to perform:
determining a configuration of the power amplification system based on power values related to the RF signal, wherein the determined configuration indicates an activation-deactivation pattern of the amplifying devices of the power amplification system for amplification of the RF signal; controlling the power amplification system according to the determined configuration for amplifying the RF signal. The power amplification system may or may not be part of the apparatus.

Example embodiments provide a method for amplifying a radio frequency (RF) signal in a power amplification system comprising multiple amplifying devices, the method comprising: determining a configuration of the power amplification system based on power values related to the RF signal, wherein the determined configuration indicates an activation-deactivation pattern of the amplifying devices of the power amplification system for amplification of the RF signal; controlling the power amplification system according to the determined configuration for amplifying the RF signal.

Example embodiments provide a computer program comprising instructions, that when executed, cause an apparatus, comprising or being connected to a power amplification system, to perform at least the following: determining a configuration of the power amplification system based on power values related to an input RF signal, wherein the determined configuration indicates an activation-deactivation pattern of amplifying devices of the power amplification system for amplification of the RF signal; operating the power amplification system in accordance with the determined configuration.

Example embodiments provide a power amplification system for amplification of radio frequency signals, the power amplification system comprising an amplifying unit, the amplifying unit being divided into two or more amplifying devices, wherein each amplifying device comprises transistor cells, wherein each transistor cell comprises a gate finger, wherein the gate fingers of each amplifying device are connected to at least one RF coupling network and have a separate gate bias specific to the amplifying device, wherein the RF coupling networks are connected to a common input terminal, wherein the transistor cells of the amplifying devices are connected to a set of one or more drain terminals, where each amplifying device of the amplifying devices is configured to receive a corresponding radio frequency signal from the common input terminal and to output an RF output signal.

### Brief Description of the Drawings

The accompanying figures are included to provide a further understanding of examples, and are incorporated in and constitute part of this specification. In the figures:
FIG. 1 illustrates a part of an exemplifying radio access network;
FIG. 2 is a flowchart of a method for amplifying RF signals using a power amplification system comprising multiple amplifying devices according to an example of the present subject matter;
FIGs. 3A-3E illustrate power amplification systems in accordance with an example of the present subject matter;
FIG. 4 depicts an apparatus for a dynamic activation of amplifying devices according to an example of the present subject matter;
FIG. 5 depicts an apparatus for a dynamic activation of amplifying devices according to an example of the present subject matter;
FIG. 6 depicts a power amplification system according to an example of the present subject matter;
FIG. 7 shows RF envelope power profiles and their corresponding control signals in accordance with an example of the present subject matter;
FIG. 8 illustrates a power amplification system in accordance with an example of the present subject matter;
FIG. 9 illustrates a power amplification system in accordance with an example of the present subject matter;
FIG. 10 a block circuit diagram illustrating a configuration of an apparatus is shown, which is configured to implement at least part of the present subject matter;
FIG. 11A is a graph illustrating an example of the relationship between the output power (in decibels relative to one milliwatt (dBm)) and the gain (in decibels (dB)) of a simulated multi-finger transistor comprising 8 active cells or 4 active cells out of 8 cells;
FIG. 11B is a graph illustrating an example of the relationship between the output power (dBm) and the efficiency (%) of a simulated multi-finger transistor comprising 8 active cells or 4 active cells out of 8 cells;
FIG. 12 illustrates a power amplification system in accordance with an example of the present subject matter;
FIG. 13 depicts an apparatus for a dynamic activation of amplifying devices according to an example of the present subject matter;
FIG. 14 illustrates a method for transition between activation states of a power amplification system in accordance with an example of the present subject matter.

### Detailed Description

In the following description, for purposes of explanation and not limitation, specific details are set forth such as particular architectures, interfaces, techniques, etc., in order to provide a thorough understanding of the examples. However, it will be apparent to those skilled in the art that the disclosed subject matter may be practiced in other illustrative examples that depart from these specific details. In some instances, detailed descriptions of well-known devices and/or methods are omitted so as not to obscure the description with unnecessary detail.

The present subject matter may allow for the activation of only a necessary set of amplifying devices to ensure their combined peak power capability can accommodate a power property of a part of the RF signal to be amplified. The set of activated amplifying devices and the set of deactivated amplifying devices during the time interval covered by the part of the RF signal may define a state of the power amplification system which may be referred to as activation state. The present subject matter may control the frequency of changes of the activation state using the activation-deactivation pattern. Controlling the frequency of changes of the activation state may be beneficial because each transition to a different activation state may slightly degrade the RF output signal quality. Furthermore, in contrast to previous techniques (such as the Doherty power amplifier), the amplifying devices in this power amplification system may not induce phase shifts or other modifications to the RF signal. The only distinction among the amplifying devices in the power amplification system may be a difference in direct current (DC) offset also called DC bias. For field effect transistor (FET) devices, the DC offset may be referred to as gate bias value or gate bias or gate bias voltage. However, the present subject matter is not limited to the FET devices.

In one example, the at least one RF coupling network may be one RF coupling network. Alternatively, the at least one RF coupling network may be multiple RF coupling networks. In one example, each gate finger may be connected to a respective RF coupling network. In another example, the RF coupling network may be connected to multiple gate fingers. For example, a gate finger contact may be connected to one or more gate fingers of the same amplifying device. The RF coupling network of the power amplification system may, for example, be a capacitor, a band pass filter, a high pass filter, a serial resonance, or a transformer. Each RF coupling network may, for example, be configured to be part of a gate finger contact of the respective amplifying device. The power amplification system is provided so that the drain contacts in the transistor cells of the amplifying devices are connected to the set of one or more drain terminals.

The power amplification system is provided so that the gate fingers of each amplifying device have a respective distinct gate bias. That is, each amplifying device of the power amplification system has its own distinct gate bias. The power amplification system may, for example, be part of a base station or a user equipment (UE) or any other device that may need amplification of an RF signal.

The RF signal which is amplified by the apparatus may, for example, be received by the apparatus or generated by the apparatus. The apparatus may, for example, be part of a base station or a user equipment (UE) or any other device that may need amplification of an RF signal.

The present subject matter may be used for applications requiring high-speed signal drivers with varying output power and/or dynamic signal quality requirements, where the applications may include, for example, satellite communication, wired communication and fiber-based communication.

The power values related to the RF signal may be a sequence of power values. For example, the sequence of power values may be derived from amplitudes of a raw composite signal from which the RF signal is obtained. The raw composite signal may, for example, be a baseband signal. In another example, the raw composite signal may be already located at RF but may still need to be processed before being received as the RF signal by the power amplification system. Alternatively, the sequence of power values may be derived from amplitudes of the RF signal. In this case, a delayed copy of the RF signal may, for example, be provided as input to the power amplification system for obtaining the amplified version of the RF signal. The RF signal may, for example, be obtained from the baseband signal by at least modulating the baseband signal with a RF carrier wave.

The activation-deactivation pattern may define an activation state of the power amplification system during each time period of a set of subsequent time periods. The set of time periods may comprise one or more time periods. The set of time periods may represent the duration of constituting parts of the RF signal respectively. The duration of the set of time periods may be the duration of the **RF** signal.

According to one example, the activation-deactivation pattern indicates for respective ones of the amplifying devices of the power amplification system one or more activation periods and/or one or more deactivation periods of the amplifying devices during a time covered by the **RF** signal.

For example, the activation-deactivation pattern may comprise an individual activation-deactivation pattern per amplifying device of the power amplification system. Each individual activation-deactivation pattern may define an activation status of the corresponding amplifying device during each time period of the set of time periods. The activation status of the amplifying device during a time period may indicate whether the amplifying device is activated or deactivated during the time period. The time period during which the amplifying device is activated may be referred to as activation period. During the activation period, the amplifying device may be partially active meaning that it amplifies a signal only during a subperiod of the activation period or fully active meaning that it amplifies a signal during the activation period. The time period during which the amplifying device is deactivated may be referred to as deactivation period.

According to one example (referred to as configuration determination example), the determining of the configuration of the power amplification system comprises: determining, along a time domain, one or more parts of the RF signal, wherein each part has a power property, for which a corresponding peak power capability is available and can be determined and which is related to a set of one or more (active) amplifying devices (large enough to serve the power property) and different from a specific peak power capability of the amplifying devices associated with a preceding part of the RF signal and/or a following part of the RF signal. The specific peak power capability may be a peak power capability. The specific peak power capability may be a power value that is large enough to serve the corresponding power property. Thus, the specific peak power capability may also be referred to as serving peak power capability. The activation-deactivation pattern indicates that during a time period that each part of the RF signal covers, an activation of the corresponding one or more amplifying devices is to be performed in order to amplify that part of the RF signal and a deactivation of non-corresponding amplifying devices is to be performed. For simplification of the description, if, for example, the power amplification system comprises a number m of amplifying devices and a part of the RF signal has a power property that corresponds with a specific peak power capability that can be provided by 2 amplifying devices, during the time period covered by the part of the RF signal, the 2 amplifying devices may be activated and the non-corresponding (i.e., remaining) m - 2 amplifying devices may be deactivated.

The specific peak power capability may be the peak power capability that is large enough or sufficiently large to amplify the corresponding part of the RF signal. Knowing the peak power capability of each amplifying device of the power amplification system, the one or more amplifying devices that corresponds with a part of the RF signal may be selected for activation such that they can provide the specific peak power capability.

Alternatively, the one or more parts of the RF signal may be defined using the baseband signal associated with the RF signal. For that, the configuration determination example may be performed using the baseband signal instead of the RF signal and the resulting one or more baseband parts may be used to determine the corresponding one or more parts of the RF signal.

For example, the determining step of the configuration determination example may result in a number N of constituting parts of the RF signal, where N is an integer higher than or equal to one. The N parts of the RF signal may, for example, be referred to as, part1,.., partN respectively. The N parts of the RF signal may cover N time periods tP1,...,tPN respectively. The N parts of the RF signal may have N power properties pw1,..., pwN respectively. For each part of the RF signal, a specific peak power capability of the power amplification system may be determined using the power property of the part of the RF signal. This may result in specific peak power capabilities mPPC1, ..., mPPCN associated with the parts part1,.., partN of the RF signal respectively. The specific peak power capability of the power amplification system may be the peak power capability of a specific subset of amplifying devices of the power amplification system. The specific peak power capability of the power amplification system that is determined for the part of the RF signal may enable to amplify that part of the RF signal using the power amplification system. Thus, it is said that the N power properties pw1,..., pwN correspond with specific peak power capabilities mPPC1, ..., mPPCN of the power amplification system respectively. The present subject matter may determine the parts of the RF signal such that: the specific peak power capability of a first (earliest) part of the RF signal is different from the specific peak power capability of the following part (i.e. second part) of the RF signal, the specific peak power capability of a last part of the RF signal is different from the specific peak power capability of the preceding part (i.e., penultimate part) of the RF signal, and the specific peak power capability of an intermediate part of the RF signal is different from the specific peak power capability of the following part of the RF signal and different from the specific peak power capability of the preceding part of the RF signal. The power amplification system comprises a set of amplifying devices. Each specific peak power capability of the specific peak power capabilities mPPC1, ..., mPPCN may be enabled by a corresponding subset of one or more amplifying devices of the power amplification system. The subset of amplifying devices may be part of the set of amplifying devices or may be the whole set of amplifying devices. Thus, the configuration determination example may result in the N parts of the RF signal being associated with N subsets of amplifying devices, sub1...subN respectively. Each consecutive pair of subsets differs, while pairs of subsets that are not consecutive may or may not be different.

Each part of the RF signal has the power property which may depend on allocated resources of the part of the RF signal, their associated power boosting, the related signal quality requirements and the performance of the RF signal processing. Therefore, in one example, the power property of a part of the RF signal may be a short-term average power of the part of the RF signal multiplied with a Peak to Average Power Ratio (PAPR). The PAPR may be referred to as linear PAPR. The short-term average power of the part of the RF signal may be determined using the baseband signal data of that part of the RF signal or using the part of the RF signal. The short-term average power of the part of the RF signal may be the average of the RF signal power values within a time interval whose duration does not exceed (e.g., smaller than) at least one threshold. For example, practical values may be about 2/BW ... 200/BW, where BW represents the RF signal bandwidth. So, there may be two thresholds, an upper threshold and a lower threshold. The upper threshold should not exceed the signal processing delay in a main path, and the lower threshold should be somewhat above the signal bandwidth equivalent. The PAPR may be large enough for satisfying the signal quality requirements. The power property according to the present subject matter may, thus, consider the mix of signal components with their individual power boosting and signal quality requirements.

Hence, for each part of the RF signal, the present subject matter may enable to activate only as many amplifying devices as necessary so that the peak power capability of the activated amplifying devices is high enough to handle the power property of the part of the RF signal.

The peak power capability of the power amplification system may be the maximum peak power, the power amplification system is capable to provide at its output with current settings of the power amplification system. This may mean that even with an increased RF input power, the RF output peak power of the power amplification system may virtually not increase. The settings may, for example, include a drain voltage or gate bias settings. The gate bias settings may define activation statuses of amplifying devices of the power amplification system which in turn determines the activation state of the power amplification system. The peak power capability may reflect a value that can be achieved reliably. This may mean that some margin (e.g., ≈0.5dB) may be left to the RF saturation power level for a parameter variation such as temperature variation, aging or process variation.

According to one example, the determining of the one or more parts of the RF signal may further be based on a criterion which may be referred to as partitioning criterion. Additionally, the determining of the one or more parts of the RF signal may performed using the number available distinct subsets of amplifying devices and their related peak power capabilities and associated power thresholds.

For example, the configuration determination example may further be based on the partitioning criterion. Indeed, though the transition (switching) between two different activation states may be quite fast (<1µs), each transition may degrade the signal quality. Hence, this example may control (e.g., limit) the number of activation state changes.

In one example, the partitioning criterion may require at least one of:
- the number of parts of the RF signal is smaller than a threshold,
- the duration of any amplifying device activation shall be configured equal or larger than an activation duration threshold,
- the overlap of the activation for different amplifying devices shall be configured equal or larger than a threshold number,
- the duration of a part of the RF signal, that requires a peak power capability higher than a first power threshold, shall be configured longer than a first duration threshold,
- the duration of a part of the RF signal, that requires a peak power capability smaller than a second power threshold, shall be configured longer than a second duration threshold, or
- a gap between two time periods of activation for each amplifying device shall be configured equal or larger than a minimum gap size. To exclude such gaps smaller than the minimum gap size, such gaps may be closed, e.g. by continuing the activation of the related amplifying devices during the gap period.

In one example, the partitioning criterion may require that the number of parts is smaller than a threshold. In one example, the partitioning criterion may require that the duration of any amplifying device activation is equal or larger than an activation duration threshold. In one example, the partitioning criterion may require that the overlap of the activation for different amplifying devices is equal or larger than a threshold number. In one example, the partitioning criterion may require that a gap between two time periods of activation for each amplifying device is equal or larger than a minimum gap.

In one example, the partitioning criterion may require that the duration of a part of the RF signal, that requires a peak power capability higher than a first power threshold, is longer than a first duration threshold. For example, if a part of the RF signal with an increased power property (which requires a higher peak power capability) is short enough, this part may be served without changing the activation state of the power amplification system, since the signal quality degradation due to a lower peak to average ratio (PAR) may be smaller due to two changes of the activation state. In the opposite direction, a part of the RF signal with a reduced power property may not be long enough for justifying energy savings associated with a change of the activation state against the related signal quality degradation.

According to one example, the controlling of the power amplification system according to the determined configuration comprises: activating or de-activating each amplifying device of the power amplification system according to the activation-deactivation pattern by applying a control signal to the amplifying device, wherein the RF signal is amplified by the activated amplifying devices.

According to one example, applying the control signal to activate the amplifying device comprises setting a DC bias of the amplifying device so that a corresponding RF signal that is input to the amplifying device can be amplified, wherein applying the control signal to deactivate the amplifying device comprises setting the DC bias of the amplifying device so that a corresponding RF signal that is input to the amplifying device is blocked from amplification. The blocked RF signal may, for example, be reflected to other (active) amplifying devices.

According to one example, the configuration is determined using the baseband signal by a Crest Factor Reduction (CFR) unit of a radio unit which comprises the power amplification system.

According to one example, the RF signal is encoded using the center frequency of a single carrier which is defined by a wireless communication system comprising the power amplification system.

According to one example, the RF signal is encoded using the center frequencies of multiple carriers which are defined by a wireless communication system comprising the power amplification system.

The wireless communication system comprises nodes such as base stations, wherein each node may serve user equipments (UEs) located within the node's geographical area of service. The wireless communication system may support one or more radio access technologies (RATs). A radio access technology of the radio access technologies may, for example, be evolved universal terrestrial radio access (E-UTRA), 5G new radio (NR), or a future 6G based system, but it is not limited to, as a person skilled in the art may apply the present subject matter to other wireless communication systems provided with necessary properties.

According to one example, the control of the power amplification system according to the determined configuration for amplifying the RF signal comprises: splitting a baseband signal associated with the RF signal such that the RF signal comprises one individual RF signal per subset of one or more active amplifying devices of the power amplification system according to the determined configuration, wherein the individual RF signals differ in phase, amplitude, or any combination thereof, inputting the individual RF signals to the respective subsets of amplifying devices and combining RF output signals from the subsets of amplifying devices for obtaining the amplified RF signal. This example may provide an alternative to the configuration determination example. In another example, the individual RF signals may differ in frequency, bandwidth or spectrum.

According to one example, the power amplification system is comprised in a radio unit. The radio unit comprises a CFR unit. The CFR unit is configured to perform an individualized crest factor reduction for each determined part of the RF signal. For example, the power limitation inside the CFR unit may be adjusted according to the power property of each part of the RF signal and/or to the associated specific peak power capability.

The dynamic control of the amplifying devices may be performed for different types of power amplification systems.

In one example, the power amplification system may be a group of amplifiers, wherein each amplifying device of the power amplification system is an amplifier of the group of amplifiers. The RF signal is distributed across all amplifiers in this group in order to obtain amplified RF signals.

In another example, the power amplification system comprises an amplifying unit. The amplifying unit is divided into two or more amplifying devices, wherein each amplifying device comprises transistor cells, wherein each transistor cell comprises a gate finger, wherein the gate fingers of each amplifying device are connected to at least one RF coupling network and have a separate gate bias specific to the amplifying device, wherein the RF coupling networks are connected to a common input terminal, wherein the transistor cells of the amplifying devices are connected to a set of one or more drain terminals, where each amplifying device of the amplifying devices is configured to receive a corresponding radio frequency signal from the common input terminal and to output an RF output signal. The RF output signal of the amplifying device may be obtained by amplifying by the amplifying device the corresponding radio frequency signal received as input at the amplifying device.

The transistor cell may comprise a gate finger and the adjacent source and drain contacts. The amplifying unit may be a multi-finger transistor. Any source or drain contact may be shared between two adjacent cells in the multi-finger transistor. In one example, the power amplification system may be integrated in a package which may contain one or more dies (chips), wherein the amplifying device comprises transistor cells on the same or different dies.

According to one example, the set of one or more drain terminals comprises multiple drain terminals such that the transistor cells of each amplifying device are connected to a corresponding drain terminal of the multiple drain terminals.

According to one example, the transistor cells of each amplifying device are adjacent cells.

According to one example, at least part of the transistor cells of each amplifying device are non-adjacent cells. In one example, the at least part of the transistor cells of each amplifying device may be all transistor cells of the amplifying device. In another example, the at least part of the transistor cells of each amplifying device may be some transistor cells of the amplifying device. For example, if the amplifying devices are of different size, the largest one may require at least some of the transistor cells being adjacent. Also with separated drain terminals, adjacent cells may be used.

According to one example, the power amplification system further comprises an RF combination and/or a matching network for directly combining the RF output signals from all amplifying devices that outputted the RF output signals.

According to one example, each amplifying device has an activation status which is defined by the gate bias of the amplifying device, wherein the activation status indicates that the amplifying device is activated or de-activated. The amplifying device is activated means that the amplifying device has an active status. The amplifying device is deactivated means that the amplifying device has an inactive status.

According to one example, a set of gate biases is provided. The set of gate biases comprises a gate bias, referred to as activation gate bias, which may enable to activate the associated amplifying device and other gate biases, referred to as deactivation gate biases, which may enable to deactivate the associated amplifying devices. Each deactivation gate bias is associated with a transition time for switching between said deactivation gate bias and the activation gate bias, wherein the gate bias of the amplifying device that defines the inactive status is associated with a specific transition time. For example, the gate bias which is set for deactivating an amplification device of the power amplification system is associated with a specific transition time e.g., the shortest transition time. The transition time may, for example, refer to a settling time required for the amplifying device in order to switch from the deactivation gate bias to the activation gate bias.

The set of gate biases may accelerate the transition between the activation states of the power amplification system to shorten the transition time and reduce the degradation of the signal quality. For example, the amplifying device, whose deactivation gate bias is associated with a transition time (e.g., the shortest transition time) which is not the longest transition time, may be in a so-called "warm-up" state.

According to one example, the activation status of the amplifying device is permanent or switchable between the active status and the inactive status.

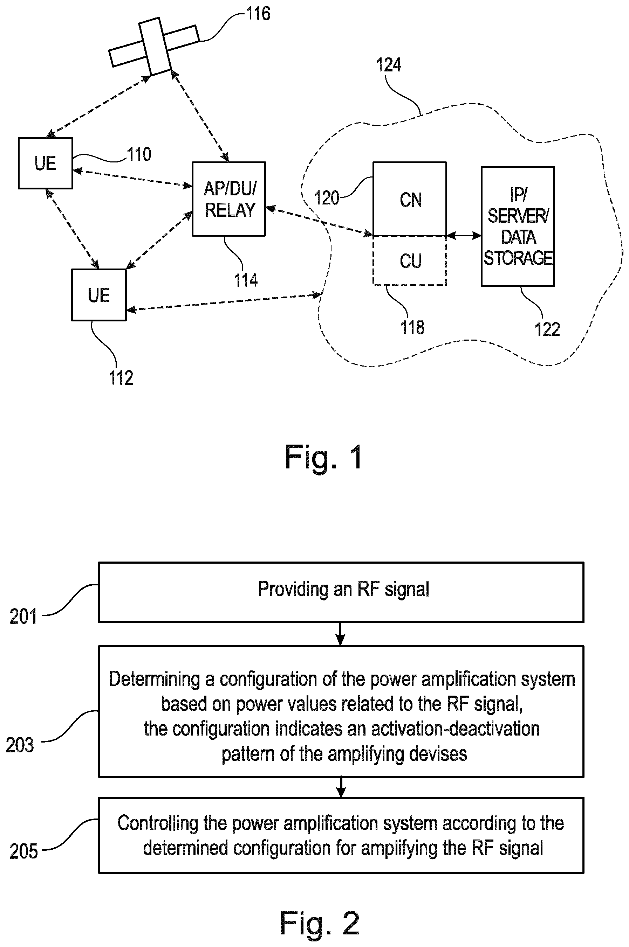

**FIG. 1** depicts examples of simplified system architectures only showing some elements and functional entities, all being logical units, whose implementation may differ from what is shown. The connections shown in FIG.1 are logical connections; the actual physical connections may be different. It is apparent to a person skilled in the art that the system typically comprises also other functions and structures than those shown in FIG.1.

The embodiments are not, however, restricted to the system given as an example but a person skilled in the art may apply the solution to other communication systems provided with necessary properties.

The example of FIG.1 shows a part of an exemplifying radio access network. FIG.1 shows devices 110 and 112. The devices 110 and 112 may, for example, be user devices. The devices 110 and 112 are configured to be in a wireless connection on one or more communication channels with a node 114. The node 114 is further connected to a core network 120. In one example, the node 114 may be an access node (such as (e/g)NodeB) 114 providing or serving devices in a cell. In one example, the node 114 may be a non-3GPP access node. The physical link from a device to a (e/g)NodeB is called uplink or reverse link and the physical link from the (e/g)NodeB to the device is called downlink or forward link. It should be appreciated that (e/g)NodeBs or their functionalities may be implemented by using any node, host, server or access point etc. entity suitable for such a usage.

A communications system typically comprises more than one (e/g)NodeB in which case the (e/g)NodeBs may also be configured to communicate with one another over links, wired or wireless, designed for the purpose. These links may be used for signaling purposes. The (e/g)NodeB is a computing device configured to control the radio resources of communication system it is coupled to. The NodeB may also be referred to as a base station, an access point or any other type of interfacing device including a relay station capable of operating in a wireless environment. The (e/g)NodeB includes or is coupled to transceivers. From the transceivers of the (e/g)NodeB, a connection is provided to an antenna unit that establishes bi-directional radio links to devices. The antenna unit may comprise a plurality of antennas or antenna elements. The (e/g)NodeB is further connected to the core network 20 (CN or next generation core NGC). For example, the (e/g)NodeB may connect to an access and mobility management function (AMF) and user plane function (UPF) in the control plane and user plane, respectively. Depending on the system, the counterpart on the CN side can be a serving gateway (S-GW, routing and forwarding user data packets), packet data network gateway (P-GW), for providing connectivity of devices (UEs) to external packet data networks, or mobile management entity (MME), etc.

The device (also called user device, UE, user equipment, user terminal, terminal device, etc.) illustrates one type of an apparatus to which resources on the air interface are allocated and assigned, and thus any feature described herein with a device may be implemented with a corresponding apparatus, such as a relay node. An example of such a relay node is a layer 3 relay (self-backhauling relay) towards the base station.

The device typically refers to a device (e.g. a portable or non-portable computing device) that includes wireless mobile communication devices operating with or without a subscriber identification module (SIM), including, but not limited to, the following types of devices: a mobile station (mobile phone), smartphone, personal digital assistant (PDA), handset, device using a wireless modem (alarm or measurement device, etc.), laptop and/or touch screen computer, tablet, game console, notebook, and multimedia device. It should be appreciated that a device may also be a nearly exclusive uplink only device, of which an example is a camera or video camera loading images or video clips to a network. A device may also be a device having capability to operate in Internet of Things (IoT) network which is a scenario in which objects are provided with the ability to transfer data over a network without requiring human-to-human or human-to-computer interaction, e.g. to be used in smart power grids and connected vehicles. The device may also utilize cloud. In some applications, a device may comprise a user portable device with radio parts (such as a watch, earphones or eyeglasses) and the computation is carried out in the cloud. The device (or in some embodiments a layer 3 relay node) is configured to perform one or more of user equipment functionalities. The device may also be called a subscriber unit, mobile station, remote terminal, access terminal, user terminal or user equipment (UE) just to mention but a few names or apparatuses.

Various techniques described herein may also be applied to a cyber-physical system (CPS) (a system of collaborating computational elements controlling physical entities). CPS may enable the implementation and exploitation of massive amounts of interconnected ICT devices (sensors, actuators, processors microcontrollers, etc.) embedded in physical objects at different locations. Mobile cyber physical systems, in which the physical system in question has inherent mobility, are a subcategory of cyber-physical systems. Examples of mobile physical systems include mobile robotics and electronics transported by humans or animals.

Additionally, although the apparatuses have been depicted as single entities, different units, processors and/or memory units (not all shown in FIG. 1) may be implemented.

5G enables using multiple input - multiple output (MIMO) antennas, many more base stations or nodes than an existing LTE system (a so-called small cell concept), including macro sites operating in co-operation with smaller stations and employing a variety of radio technologies depending on service needs, use cases and/or spectrum available. 5G mobile communications supports a wide range of use cases and related applications including video streaming, augmented reality, different ways of data sharing and various forms of machine type applications (such as (massive) machine-type communications (mMTC), including vehicular safety, different sensors and real-time control. 5G is expected to have multiple radio interfaces, namely below 6GHz, cmWave and mmWave, and also being integrable with existing legacy radio access technologies, such as the LTE. Integration with the LTE may be implemented, at least in the early phase, as a system, where macro coverage is provided by the LTE and 5G radio interface access comes from small cells by aggregation to the LTE. In other words, 5G is planned to support both inter-RAT operability (such as LTE-5G) and inter-RI operability (inter-radio interface operability, such as below 6GHz - cmWave, below 6GHz - cmWave - mmWave). One of the concepts considered to be used in 5G networks is network slicing in which multiple independent and dedicated virtual sub-networks (network instances) may be created within the same infrastructure to run services that have different requirements on latency, reliability, throughput and mobility.

The current architecture in LTE networks is fully distributed in the radio and fully centralized in the core network. The low latency applications and services in 5G require to bring the content close to the radio which leads to local break out and multi-access edge computing (MEC). 5G enables analytics and knowledge generation to occur at the source of the data. This approach requires leveraging resources that may not be continuously connected to a network such as laptops, smartphones, tablets and sensors. MEC provides a distributed computing environment for application and service hosting. It also has the ability to store and process content in close proximity to cellular subscribers for faster response time. Edge computing covers a wide range of technologies such as wireless sensor networks, mobile data acquisition, mobile signature analysis, cooperative distributed peer-to-peer ad hoc networking and processing also classifiable as local cloud/fog computing and grid/mesh computing, dew computing, mobile edge computing, cloudlet, distributed data storage and retrieval, autonomic self-healing networks, remote cloud services, augmented and virtual reality, data caching, Internet of Things (massive connectivity and/or latency critical), critical communications (autonomous vehicles, traffic safety, real-time analytics, time-critical control, healthcare applications).

The communication system is also able to communicate with other networks, such as a public switched telephone network or the Internet as illustrated by the component referenced by reference numeral 122, or utilize services provided by them. The communication network may also be able to support the usage of cloud services, for example at least part of core network operations may be carried out as a cloud service (this is depicted in FIG.1 by "cloud" 124). The communication system may also comprise a central control entity, or a like, providing facilities for networks of different operators to cooperate for example in spectrum sharing.

The technology of Edge cloud may be brought into a radio access network (RAN) by utilizing network function virtualization (NVF) and software defined networking (SDN). Using the technology of edge cloud may mean access node operations to be carried out, at least partly, in a server, host or node operationally coupled to a remote radio head or base station comprising radio parts. It is also possible that node operations will be distributed among a plurality of servers, nodes or hosts. Application of cloudRAN architecture enables RAN real time functions being carried out at the RAN side (in a distributed unit, DU 114) and non-real time functions being carried out in a centralized manner (in a centralized unit, CU 118).

It should also be understood that the distribution of labour between core network operations and base station operations may differ from that of the LTE or even be non-existent. Some other technology advancements probably to be used are Big Data and all-IP, which may change the way networks are being constructed and managed. 5G is being designed to support multiple hierarchies, where MEC servers can be placed between the core and the base station or nodeB (gNB). It should be appreciated that MEC can be applied in 4G networks as well.

5G may also utilize satellite communication to enhance or complement the coverage of 5G service, for example by providing backhauling. Possible use cases are providing service continuity for machine-to-machine (M2M) or Internet of Things (IoT) devices or for passengers on board of vehicles, or ensuring service availability for critical communications, and future railway/maritime/aeronautical communications. Satellite communication may utilize geostationary earth orbit (GEO) satellite systems, but also low earth orbit (LEO) satellite systems, in particular mega-constellations (systems in which hundreds of (nano)satellites are deployed). Each satellite 116 in the mega-constellation may cover several satellite-enabled network entities that create on-ground cells. The on-ground cells may be created via an on-ground relay node 114 or by a gNB located on-ground or in a satellite.

It is understandable for a person skilled in the art that the depicted system is only an example of a part of a radio access system and in practice, the system may comprise a plurality of (e/g)NodeBs, the device may have an access to a plurality of radio cells and the system may comprise also other apparatuses, such as physical layer relay nodes or other network elements, etc. One of the (e/g)NodeBs or may be a Home(e/g)nodeB. Additionally, in a geographical area of a radio communication system a plurality of different kinds of radio cells as well as a plurality of radio cells may be provided. Radio cells may be macro cells (or umbrella cells) which are large cells, usually having a diameter of up to tens of kilometers, or smaller cells such as micro-, femto- or picocells. The (e/g)NodeBs of FIG.1 may provide any kind of these cells. A cellular radio system may be implemented as a multilayer network including several kinds of cells. Typically, in multilayer networks, one access node provides one kind of a cell or cells, and thus a plurality of (e/g)NodeBs are required to provide such a network structure.

For fulfilling the need for improving the deployment and performance of communication systems, the concept of "plug-and-play" (e/g)NodeBs has been introduced. Typically, a network which is able to use "plug-and-play" (e/g)Node Bs, includes, in addition to Home (e/g)NodeBs (H(e/g)nodeBs), a home node B gateway, or HNB-GW (not shown in FIG.1). A HNB Gateway (HNB-GW), which is typically installed within an operator's network may aggregate traffic from a large number of HNBs back to a core network.

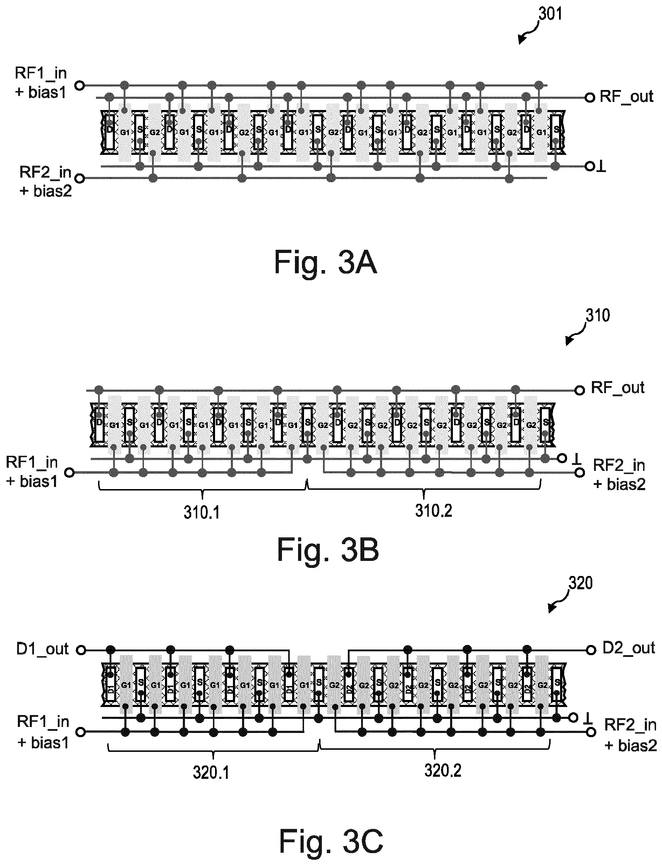

**FIG. 2** is a flowchart of a method for amplifying radio frequency (RF) signals using a power amplification system comprising multiple amplifying devices according to an example of the present subject matter. For the purpose of explanation, the method described in FIG 2 may be implemented in the system illustrated in FIG. 1, but is not limited to this implementation. The method may, for example, be performed by an apparatus which is part of the node 114 or part of a UE such as UEs 110 and 112. The apparatus may comprise the power amplification system. The power amplification system may, for example, be any one of the power amplification systems described with reference to FIGs. 3A-3E, 6, 8, 9 and 12.

An RF signal may be provided in step 201 e.g., the RF signal may be received or generated in step 201. A configuration of the power amplification system may be determined in step 203 based on the power values related to the RF signal. The configuration indicates an activation-deactivation pattern of the amplifying devices of the power amplification system for amplification of the RF signal. The power amplification system may be controlled in step 205 according to the determined configuration for amplifying the RF signal.

**FIG. 3A** illustrates a power amplification system in accordance with an example of the present subject matter. As shown in FIG. 3A, the power amplification system comprises a multi-finger transistor 301. The transistor layout of the multi-finger transistor 301 shows a longitudinal channel region being crossed by gate fingers (G). Between the gate fingers, there are alternating source (S) and drain (D) contacts. Each gate finger together with its adjacent source and drain contacts belong to a transistor cell, where source and drain contacts are shared between adjacent transistor cells. The multi-finger transistor 301 has an interleaved transistor structure. In this interleaved transistor structure, every third gate finger (G2) belongs to an amplifying device (transistor2) and is connected to an input terminal RF2_in for receiving an RF signal, whereas the remaining gate fingers (G1) belong to an amplifying device (transistor1) and are connected to the input terminal RF1_in for receiving the RF signal. The gate fingers that belong to the amplifying device transistor1 are referred to as G1, and gate fingers that belong to the amplifying device transistor2 are referred to as G2.

In addition to the RF signal, an external control signal may be applied to each amplifying device of the power amplification system. This control signal may activate or de-activate the corresponding amplifying device. The control signal may change the gate bias of each gate finger of the amplifying device between two gate bias values (referred to as bias1 and bias2 in FIG. 3A), at which the RF signal is either blocked or amplified. A change of the gate bias value can be applied quite fast, which may allow for an autonomous control inside a radio unit.

The source contacts of the multi-finger transistor 301 may be connected together using metal layers within the multi-finger transistor 301. The source contacts may be connected to ground using bond wires. The drain contacts of the multi-finger transistor 301 may be connected together using metal layers within the multi-finger transistor 301. The drain contacts may be connected to a drain terminal RF_out using bond wires. These drain connection and bond wires may, for example, be secured by a transistor package. The transistor package may be the housing for one or more dies, wherein the die may contain several transistor cells of the multi-finger transistor 301.

As illustrated in FIG. 3A, the amplified RF signals may be combined to a common RF output signal which may be provided at the output terminal RF_out.

As described with reference to FIG. 3A, the amplifying device transistor1 has twice as many gate fingers as the amplifying device transistor2 and hence can provide twice the output power.

**FIG. 3B** illustrates a power amplification system in accordance with an example of the present subject matter. As shown in FIG. 3B, the power amplification system comprises a multi-finger transistor 310. The transistor layout of the multi-finger transistor 310 shows a longitudinal channel region being crossed by gate fingers (G). Between the gate fingers, there are alternating source (S) and drain (D) contacts. Each gate finger together with its adjacent source and drain contacts belong to a transistor cell, where source and drain contacts are shared between adjacent transistor cells. The multi-finger transistor 310 has a segmented transistor structure. In this segmented transistor structure, adjacent gate fingers are combined within two segments 310.1 and 310.2. Such a structure may require minor changes to existing transistor designs and allow a simple routing within the transistor package. The two segments 310.1 and 310.2 may define two amplifying devices respectively. The gate fingers that belong to the amplifying device 310.1 are referred to as G1, and gate fingers that belong to the amplifying device 310.2 are referred to as G2. Each gate finger G2 of the amplifying device 310.2 is connected to an input terminal RF2_in for receiving an RF signal. Each gate finger G1 of the amplifying device 310.1 is connected to an input terminal RF1_in for receiving the RF signal.

In addition to the RF signal, an external control signal may be applied to each amplifying device of the power amplification system. This control signal may activate or de-activate the corresponding amplifying device. The control signal may change the gate bias of each gate finger of the amplifying device between two gate bias values (referred to as bias1 and bias2 in FIG. 3B), at which the RF signal is either blocked or amplified. A change of the gate bias value can be applied quite fast, which may allow for an autonomous control inside a radio unit.

The source contacts of the multi-finger transistor 310 may be connected together using metal layers within the multi-finger transistor 310. The source contacts may be connected to ground using bond wires. The drain contacts of the multi-finger transistor 310 may be connected together using metal layers within the multi-finger transistor 310. The drain contacts may be connected to a drain terminal RF_out using bond wires. These drain connection and bond wires may be secured by the transistor package. As illustrated in FIG. 3B, the amplified RF signals may be combined to a common RF output signal which may be provided at the output terminal RF_out.

**FIG. 3C** illustrates a power amplification system in accordance with an example of the present subject matter. As shown in FIG. 3C, the power amplification system comprises a multi-finger transistor 320. The multi-finger transistor 320 has a segmented transistor structure as described with reference to FIG. 3B. The multi-finger transistor 320 is similar to the multi-finger transistor 310, except for the distinction that their drain contacts are linked to separate drain terminals. The drain contacts of the amplifying device 320.1 may be connected to a drain terminal D1_out while drain contacts of the amplifying device 320.2 may be connected to a drain terminal D2_out.

The amplified RF signals of the amplifying device 320.1 may be combined to a common RF output signal which may be provided at the drain terminal D1_out. The amplified RF signals of the amplifying device 320.2 may be combined to a common RF output signal which may be provided at the drain terminal D2_out. Standard power combining method may be used to combine the outputs at the two drain terminals D1_out and D2_out. Each of the drain terminals D1_out and D2_out may be connected to a different drain voltage.

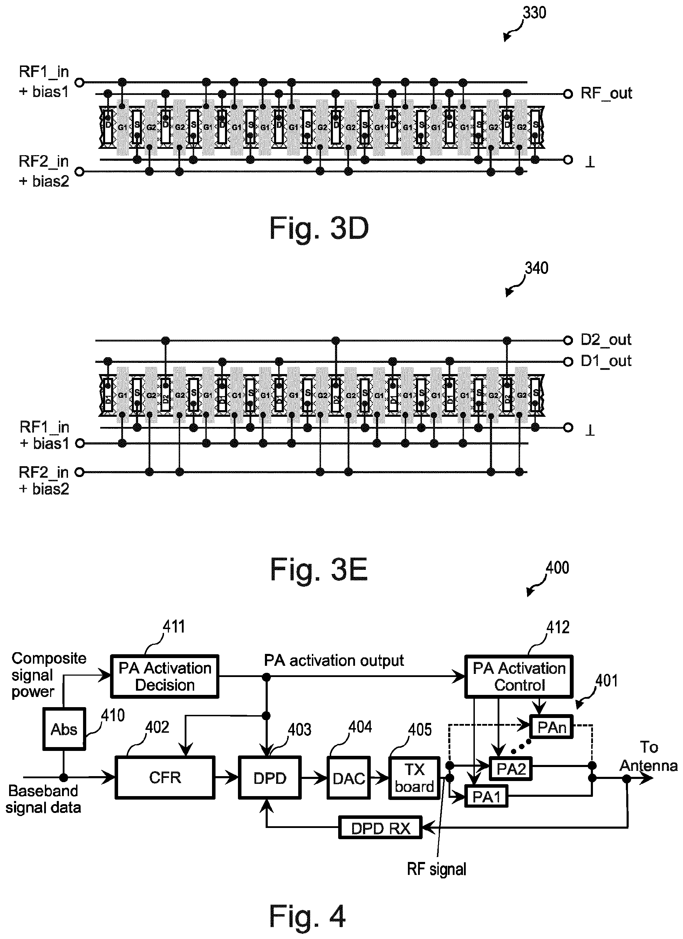

**FIG. 3D** illustrates a power amplification system in accordance with an example of the present subject matter. As shown in FIG. 3D, the power amplification system comprises a multi-finger transistor 330. The multi-finger transistor 330 has an interleaved transistor structure defining two amplifying devices. Each drain contact is surrounded by two gate fingers being associated with the same gate bias value. The gate fingers that belong to one amplifying device are referred to as G1, and gate fingers that belong to another amplifying device are referred to as G2. Each gate finger G1 of the amplifying device is connected to an input terminal RF1_in for receiving an RF signal. Each gate finger G2 of the other amplifying device is connected to an input terminal RF2_in for receiving the RF signal. The drain contacts of the amplifying devices may be connected to a drain terminal RF_out. The amplifying device (of gate fingers G1) comprises multiple first subsets of transistor cells, where each first subset of transistor cells comprises four adjacent transistor cells. The other amplifying device (of gate fingers G2) comprises multiple second subsets of transistor cells, where each second subset of transistor cells comprises two adjacent transistor cells. The first and second subsets are interleaved subsets.

The amplified RF signals may be combined to a common RF output signal which may be provided at the drain terminal RF_out.

**FIG. 3E** illustrates a power amplification system in accordance with an example of the present subject matter. As shown in FIG. 3E, the power amplification system comprises a multi-finger transistor 340. The multi-finger transistor 340 has an interleaved transistor structure defining two amplifying devices. Each drain contact is surrounded by two gate fingers being associated with the same gate bias value. The gate fingers that belong to one amplifying device are referred to as G1, and gate fingers that belong to another amplifying device are referred to as G2. Each gate finger G1 of the amplifying device is connected to an input terminal RF1_in for receiving an RF signal. Each gate finger G2 of the other amplifying device is connected to an input terminal RF2_in for receiving the RF signal. The drain contacts of the amplifying device may be connected to a drain terminal D1_out while drain contacts of the other amplifying device may be connected to a drain terminal D2_out.

The amplifying device (of gate fingers G1) comprises multiple first subsets of transistor cells, where each first subset of transistor cells comprises four adjacent transistor cells. The other amplifying device (of gate fingers G2) comprises multiple second subsets of transistor cells, where each second subset of transistor cells comprises two adjacent cells. The first and second subsets are interleaved subsets.

The amplified RF signals of the amplifying device may be combined to a common RF output signal which may be provided at the drain terminal D1_out. The amplified RF signals of the other amplifying device may be combined to a common RF output signal which may be provided at the drain terminal D2_out. Standard power combining methods may be used to combine the outputs at the two drain terminals D1_out and D2_out.

**FIG. 4** depicts an apparatus 400 for a dynamic activation of amplifying devices according to an example of the present subject matter.

The apparatus 400 comprises a power amplification system 401. The power amplification system 401 comprises amplifying devices PA1 through PAn. The apparatus 400 comprises a CFR unit 402, DPD unit 403, DAC unit 404 and transmit (TX) board 405. The execution of functions or tasks of the units 402 through 412 of the apparatus 400 may, for example, be performed or controlled by using a memory and a processor (e.g., Digital Signal Processor (DSP) or Central Processing Unit (CPU)).

The apparatus 400 further comprises an abs unit 410. The abs unit 410 may derive a composite signal power from baseband signal data. As indicated in FIG. 4, this derivation can happen before the CFR unit 402 may process the baseband signal data. The CFR unit 402 may introduce some latency to the signal, which may give the composite signal power some preview property.

Based on the composite signal power, a PA Activation Decision unit 411 of the apparatus 400 may evaluate a decision for the activation of each amplifying device PA1 though PAn. The decision may be provided as an activation-deactivation pattern in the PA activation output. The PA activation output is received by the CFR unit 402, DPD unit 403 and a PA Activation Control unit 412.

Depending on the PA activation output, the CFR unit 402 may adjust their parameters (e.g. a clipping threshold) such that the peak power capability of the active PA part is not exceeded. This may represent a multi-level CFR. The PA Activation Control unit 412 may determine a control signal for each amplifying device PA1 through PAn using the activation-deactivation pattern. The PA Activation Control unit 412 may distribute the corresponding control signal to each amplifying device PA1 through PAn and thus controls the activation status of each amplifying device. The DPD unit 403 may be aware of both, the activation status for the amplifying devices PA1 though PAn in each activation state of the power amplification system 401 and the transitions between different activation states. Consequently, the DPD unit 403 may use a different set of linearization parameters for each activation state. Furthermore, the DPD unit 403 may compensate pulses which occur during each transition between different activation states. A resulting pre-distorted signal of the DPD unit 403 may be transformed to an analog signal by the DAC unit 404. The analog signal may then be processed (as known in the art) by the TX Board 405 in order to be amplified by the power amplification system 401 in accordance with the control signals. The pre-distorted signal may be upconverted to RF in the DAC unit 404 or TX board 405.

The DPD unit 403 may permanently monitor, using a DPD RX, the RF output of the power amplification system 401 for an adaptation of its internal parameters.

Although FIG. 4 depicts the apparatus receiving baseband signal data to perform a task of delivering the RF signal to the power amplification system 401 and the composite signal power to the PA Activation Decision unit 411 as described above, it could alternatively receive an RF signal in digital format to perform the task.

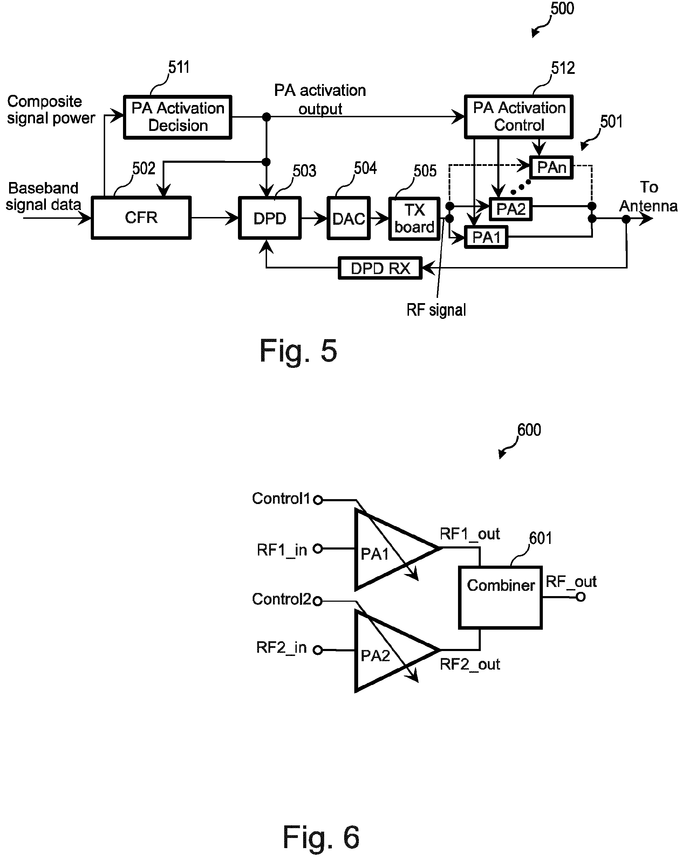

**FIG. 5** depicts an apparatus 500 for a dynamic activation of amplifying devices according to an example of the present subject matter.

The apparatus 500 comprises a power amplification system 501. The power amplification system 501 comprises amplifying devices PA1 through PAn. The apparatus 500 comprises a CFR unit 502, DPD unit 503, DAC unit 504 and TX board 505. The execution of functions or tasks of the units 502 through 512 of the apparatus 500 may, for example, be performed or controlled by using a memory and a processor (e.g., DSP or CPU).

The CFR unit 502 may derive a composite signal power from baseband signal data. Based on this composite signal power, a PA Activation Decision unit 511 of the apparatus 500 may evaluate a decision for the activation of each amplifying device PA1 though PAn. The decision may be provided as an activation-deactivation pattern in the PA activation output. The PA activation output is received by the CFR unit 502, DPD unit 503 and a PA Activation Control unit 512.

Depending on the PA activation output, the CFR unit 502 may adjust their parameters (e.g. a clipping threshold) such that the peak power capability of the active PA part is not exceeded. This may represent a multi-level CFR. The PA Activation Control unit 512 may determine a control signal for each amplifying device PA1 through PAn using the activation-deactivation pattern. The PA Activation Control unit 512 may distribute the corresponding control signal to each amplifying device PA1 through PAn and thus controls the activation status of each amplifying device. The DPD unit 503 may be aware of both, the activation status for the amplifying devices PA1 though PAn in each activation state of the power amplification system 501 and the transitions between different activation states. Consequently, the DPD unit 503 may use a different set of linearization parameters for each activation state. Furthermore, the DPD unit 503 may compensate pulses which occur during each transition between different activation states. A resulting pre-distorted signal of the DPD unit 502 may be transformed to an analog signal by the DAC unit 504. The analog signal may then be processed (as known in the art) by the TX Board 505 in order to be amplified by the power amplification system 501 in accordance with the control signals. The pre-distorted signal may be upconverted to RF in the DAC unit 504 or TX board 505.

The DPD unit 503 may permanently monitor, using a DPD RX, the RF output of the power amplification system 501 for an adaptation of its internal parameters.

In an alternative implementation of the apparatus of Fig. 5, the CFR unit 502 and the PA Activation Decision unit 511 may be combined. This may be advantageous since the interaction between these two units may be quite large, especially because the clipping threshold may be related to the peak power property of the PA, and the peak power property is controlled by the PA activation signal.

Although FIG. 5 depicts the apparatus receiving baseband signal data to perform a task of delivering the RF signal to the power amplification system 501 and the composite signal power to the PA Activation Decision unit 511 as described above, it could alternatively receive an RF signal in digital format to perform the task.

**FIG. 6** depicts a power amplification system 600 according to an example of the present subject matter.

The power amplification system 600 comprises two amplifying devices PA1 and PA2, wherein each amplifying device may be an independent amplifier. Alternatively, the combination of the two amplifying devices PA1 and PA2 may be achieved by a combination of multiple dies within a same package e.g., in accordance with a segmented and/or an interleaved structure of a multi-finger transistor as described with reference to FIGs. 3A-3E.

The amplifying device PA1 may receive an input RF signal at input terminal RF1_in and may provide an output RF signal at drain terminal RF1_out based on a control signal control1. The amplifying device PA2 may receive an input RF signal at input terminal RF2_in and may provide an output RF signal at drain terminal RF2_out based on a control signal control2. A combiner 601 may combine the output RF signals from drain terminals RF1_out and RF2_out in order to provide the output RF signal at the drain terminal RF_out. The combiner 601 may use a standard power combining method.

In one example implementation of the power amplification system 600 of FIG. 6, the amplifying device PA1 may consist of at least two amplifying devices according to the present subject matter and the amplifying device PA2 may be an additional (separate) amplifier, which may also consist of several amplifying devices. This may allow to utilize the present subject matter in an "extended" Doherty amplifier, where the main PA may consist of amplifying devices according to the present subject matter and the peak amplifier may or may not be according to the present subject matter.

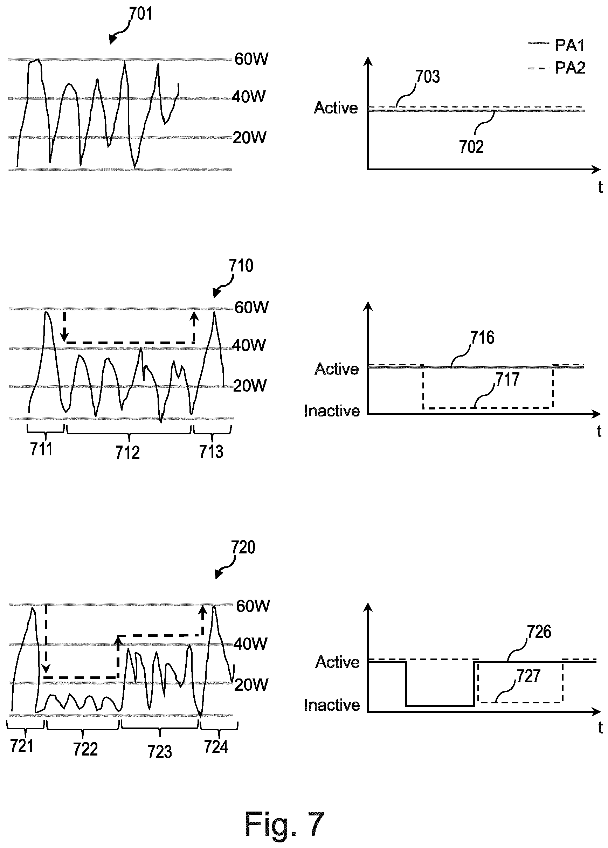

**FIG. 7** illustrates RF envelope power profiles which may be already clipped and their corresponding control signals in accordance with an example of the present subject matter. FIG. 7 may be described with reference to the power amplification system of FIG. 6. The RF envelope power profile may illustrate a power amplifier combined output.

FIG. 7 shows an example where amplifying device PA1 has a peak power capability of 40W and amplifying device PA2 has a peak power capability of 20W. FIG. 7 shows three different RF envelope power profiles 701, 710 and 720.

In the RF envelope power profile 701, the time periods during which the RF envelope power falls at or below 40W are too short for a de-activation of amplifying device PA2. Hence, both amplifying devices PA1 and PA2 are active during the whole duration of the RF envelope power profile 701. This is indicated by the control signals 702 and 703 for the amplifying devices PA1 and PA2 respectively.

In the RF envelope power profile 710, the RF envelope power falls at or below 40W for a longer time period. This may define three parts 711, 712 and 713 of the RF envelope power profile 710. The control signal 716 may activate the amplifying device PA1 during the whole duration of the RF envelope power profile 710. The control signal 717 may activate the amplifying device PA2 during the parts 711 and 713 of the RF envelope power profile 710 and deactivate the amplifying device PA2 during the part 712 of the RF envelope power profile 710.

The reduction of the envelope power profile 710 may be detected before the digital signal processing. The latency of the signal processing block provides enough time to decide that it is worth to de-activate the amplifying device PA2. The same latency also allows activating amplifying device PA2 in time so that it is available again when or shortly before the full peak power capability is requested.

In the RF envelope power profile 720, a larger drop of the RF envelope power at or below 20W may be detected. This may define four parts 721, 722, 723 and 723 of the RF envelope power profile 720. The control signal 726 may activate the amplifying device PA1 during the parts 721, 723 and 724 of the RF envelope power profile 720 and deactivate the amplifying device PA1 during the part 722 of the RF envelope power profile 720. The control signal 727 may activate the amplifying device PA2 during the parts 721, 722 and 724 of the RF envelope power profile 720 and deactivate the amplifying device PA2 during the part 723 of the RF envelope power profile 720. This may allow the de-activation of amplifying device PA1, while amplifying device PA2 is activated. When the RF envelope power profile 720 is above 20W but is still does not exceed 40W, amplifying device PA2 may be de-activated while amplifying device PA1 is active.

Amplifying device PA1 may be activated before amplifying device PA2 may be de-activated to avoid RF signal dropouts.

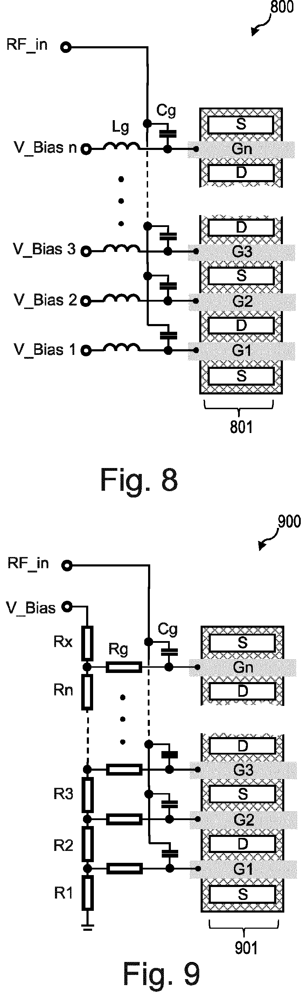

**FIG. 8** illustrates a power amplification system 800 in accordance with an example of the present subject matter. The power amplification system 800 comprises a multi-finger transistor 801. The transistor layout of the multi-finger transistor 801 shows a long channel region being crossed by gate fingers (G1 through Gn). Between the gate fingers, there are alternating source (S) and drain (D) contacts. Each gate finger together with its adjacent source and drain contacts belong to a cell, where source and drain contacts are shared between adjacent cells. FIG. 8 shows an example for gradually increasing gate bias value. A group of one or more gate fingers with the highest gate bias value "V_Bias 1" is permanently operating in class AB and the related transistor cells are active at all signal power levels. A group of one or more gate fingers with the second highest gate bias value "V_Bias 2" operates in class C and the related transistor cells become active, if the signal power exceeds a first power level. There can be further groups of one or more gate fingers with even lower gate bias values "V_Bias 3 ... V_Bias n" operating in class C, the related transistor cells of which become active above higher power levels. The RF input signal at the input terminal RF_in is provided via capacitive coupling over capacitors Cg, while the gate bias values are provided via inductances Lg, which can be bonding wires. The gate inductances Lg may be replaced by resistors Rg in the power amplification system 800. Using resistors instead of inductors may reduce the frequency selectivity. The activation of related transistor cells of the power amplification system 800 may be completely controlled by the RF signal power and may depend on the selected static gate bias values. No other control signal may be provided. In the case of gradually increasing gate bias value, no dynamic change of the CFR parameters may be needed.

Hence, contrary to the power amplification systems of FIGs. 3A-3E and FIG. 6, the activation of amplifying devices of the power amplification system 800 may happen directly by the input RF signal. For example, gate fingers of each amplifying device may have a static but different gate bias value and the related amplifying devices may become active if the RF input power is large enough. In other words, the related transistor cells of any amplifying device may become active in time intervals, during which the sum of the (RF) signal amplitude together with the gate bias of the amplifying device exceeds the activation threshold of the related transistor cells of the amplifying device.

**FIG. 9** illustrates a power amplification system 900 in accordance with an example of the present subject matter. The power amplification system 900 comprises a multi-finger transistor 901. The transistor layout of the multi-finger transistor 901 shows a long channel region being crossed by gate fingers (G1 through Gn). Between the gate fingers, there are alternating source (S) and drain (D) contacts. Each gate finger together with its adjacent source and drain contacts belong to a cell, where source and drain contacts are shared between adjacent cells. FIG. 9 shows an example for the provision of a gradually increasing gate bias value. This provision may be integrated into the transistor layout. The gradually gate bias value is provided via a chain of resistors R1, R2, R3, ..., Rn, Rx which is connected between a DC bias voltage V_Bias and ground. For example, V_Bias may be negative. The resistors in this chain do not necessarily have to be equal and shall be tuned for optimum transistor operating points. All gates shall be fed from the same RF input signal obtained from the input terminal RF_in via capacitive coupling over Cg. Cg can have the same value for every gate and shall be much larger than the gate-channel capacitance. The gate resistors Rg may be replaced by inductances, which may have a resistive component. Bond wires may be an example for such a replacement.

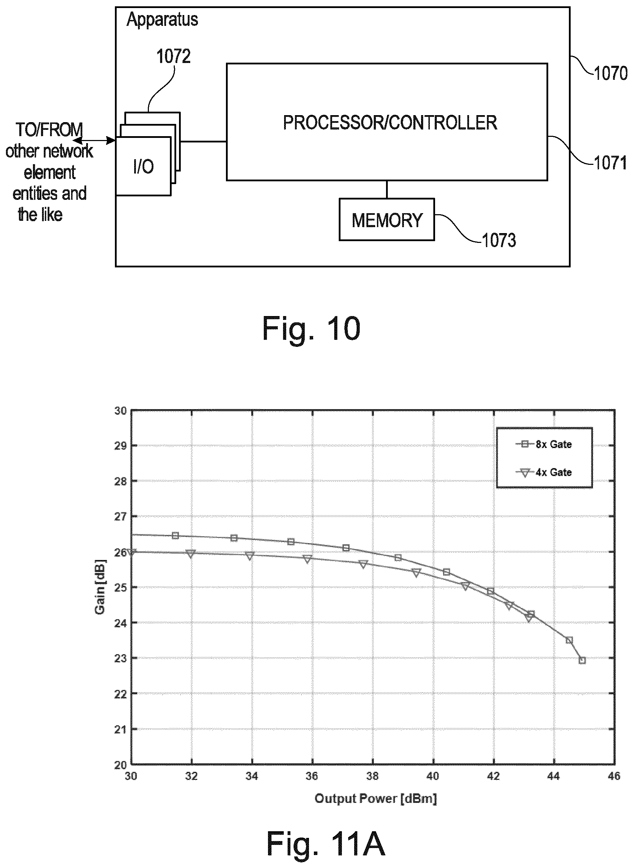

In **FIG. 10****,** a block circuit diagram illustrating a configuration of an apparatus 1070 is shown, which is configured to implement at least part of the present subject matter. It is to be noted that the apparatus 1070 shown in FIG. 10 may comprise several further elements or functions besides those described herein below, which are omitted herein for the sake of simplicity as they are not essential for the understanding. Furthermore, the apparatus may be also another device having a similar function, such as a chipset, a chip, a module etc., which can also be part of an apparatus or attached as a separate element to the apparatus 1070, or the like. The apparatus 1070 may comprise a processing function or processor 1071, such as a central processing unit (CPU) or the like, which executes instructions given by programs or the like related to a flow control mechanism. The processor 1071 may comprise one or more processing portions dedicated to specific processing as described below, or the processing may be run in a single processor. Portions for executing such specific processing may be also provided as discrete elements or within one or more further processors or processing portions, such as in one physical processor like a CPU or in several physical entities, for example. Reference sign 1072 denotes transceiver or input/output (I/O) units (interfaces) connected to the processor 1071. The I/O units 1072 may be used for communicating with one or more other network elements, entities, terminals or the like. The I/O units 1072 may be a combined unit comprising communication equipment towards several network elements or may comprise a distributed structure with a plurality of different interfaces for different network elements. Reference sign 1073 denotes a memory usable, for example, for storing data and programs to be executed by the processor 1071 and/or as a working storage of the processor 1071.

The processor 1071 is configured to execute processing related to the above described subject matter. In particular, the apparatus 1070 may be configured to perform the method as described in connection with FIG 2.

For example, the processor 1071 is configured for: determining a configuration of the power amplification system based on power values of an RF signal, wherein the configuration indicates an activation-deactivation pattern of the amplifying devices of the power amplification system for amplification of the RF signal, and controlling the power amplification system according to the determined configuration for amplifying the RF signal.

**FIG. 11A** is a graph illustrating an example of the relationship between the output power (dBm) and the gain (dB) of a simulated multi-finger transistor comprising 8 active transistor cells or 4 active transistor cells out of 8 transistor cells. From FIG. 11A, it may be evident that deactivating 4 out of 8 (active) transistor cells let the gain drop by just about 0.5dB, which may be sufficient for typical digital predistortion requirement.

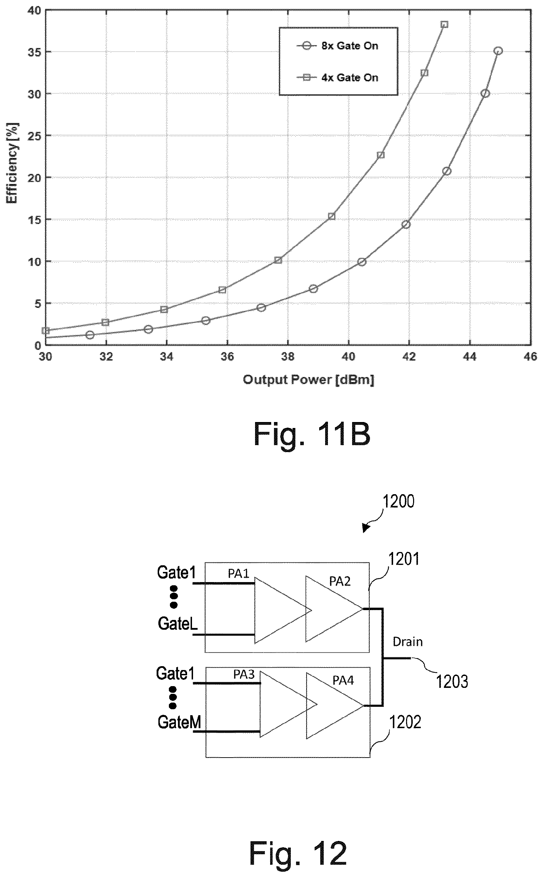

**FIG. 11B** is a graph illustrating an example of the relationship between the output power (dBm) and the drain efficiency (%) of a simulated multi-finger transistor comprising 8 active transistor cells or 4 active transistor cells out of 8 transistor cells. As shown, with increased output power, the drain efficiency increases with 4 activated transistor cells compared to 8 activated transistor cells. This may increase the backoff efficiency of the power amplification system due to a scaled down version of the same transistor with reduced transistor cell activation.

**FIG. 12** illustrates a power amplification system 1200 in accordance with an example of the present subject matter. The power amplification system 1200 comprises two amplifying devices 1201 and 1202. The amplifying device 1201 comprises two cascaded individual amplifying devices PA1 and PA2. The output of the individual amplifying device PA1 is amplified by the individual amplifying device PA2. The amplifying device 1202 comprises two cascaded individual amplifying devices PA3 and PA4. The output of the individual amplifying device PA3 is amplified by the individual amplifying device PA4. As shown, any of the amplifying devices 1201 and 1202 is organized in a two-stage configuration. Each stage comprises one individual amplifying device. The amplifying devices 1201 and 1202 are connected to a single drain terminal 1203. As shown, each of the individual amplifying devices PA1 and PA3 is associated a respective number of gate terminals. For example, each of the individual amplifying devices PA1 and PA3 may be provided as described with reference to amplifying devices of FIGs 3C or 3E. Since PA2 and PA4 are connected to a single drain terminal, these individual amplifying devices may be provided preferably as in Figs. 3A, 3B and 3D (but also as in Figs. 3C and 3E together with a combining of the separate drain terminals).

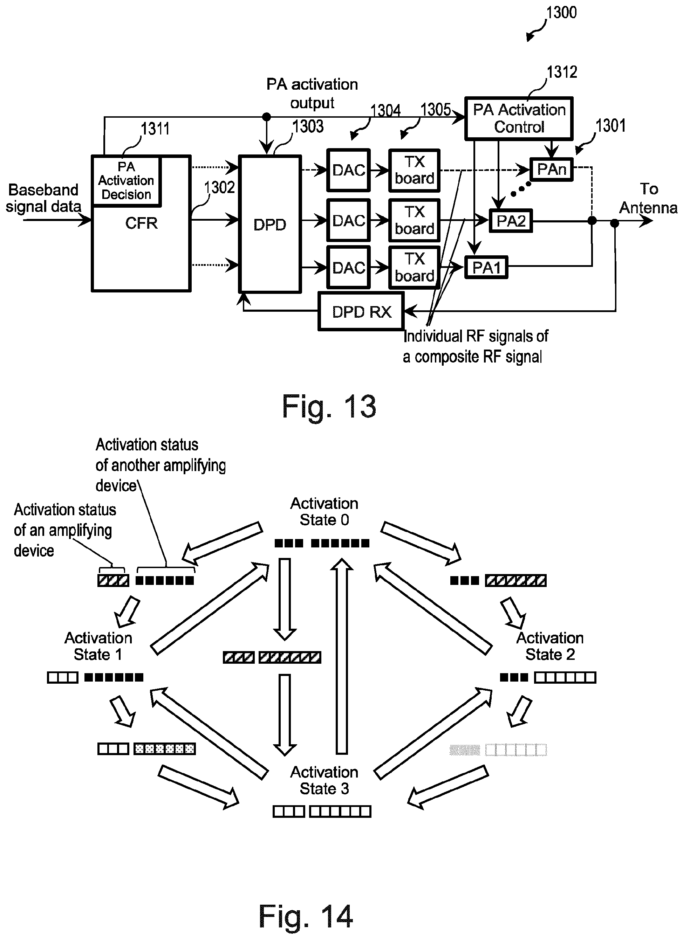

**FIG. 13** depicts an apparatus 1300 for a dynamic activation of amplifying devices according to an example of the present subject matter.

The apparatus 1300 comprises a power amplifying system 1301. The power amplifying system 1301 comprises amplifying devices PA1 through PAn. The apparatus 1300 comprises a CFR unit 1302, DPD unit 1303, a set of DAC units 1304 and a set of TX boards 1305. The CFR unit 1302 may comprise a PA Activation Decision unit 1311.

The CFR unit 1302 may derive a composite signal power from baseband signal data. Based on this composite signal power, the PA Activation Decision unit 1311 may evaluate a decision for the activation of each amplifying device PA1 though PAn. The decision may be provided as an activation-deactivation pattern in the PA activation output. The PA activation output is received by the DPD unit 1303 and a PA Activation Control unit 1312.

As indicated in FIG. 13, the baseband signal data may be split into signal components, each of them being dedicated to an amplifying device of the power amplification system 1301. This splitting may be performed either within or in front of the CFR unit 1302 or within the DPD unit 1303. Consequently, with this method each amplifying device may be fed by a different individual RF signal that is processed by respective DAC unit and TX board.

If the splitting is performed inside the DPD unit, just a single signal may be delivered from the CFR unit 1302 to the DPD unit 1303. The bandwidth expansion of the pre-distorted signals can be limited at the costs of additional HW elements. As in FIGs. 4 and 5, the signal processing of the baseband signal data may result in a delay which is sufficiently long to obtain a preview for the requested peak power directly from this baseband signal data inside the PA Activation Decision unit 1311. The method of FIG. 13 may compensate for the change of the PA properties (e.g. gain, phase response, frequency response, trapping, memory effects and nonlinearity) during activation or de-activation of amplifying devices.

To illustrate the function of the signal splitting in FIG. 13, the procedure for requesting a higher peak power capability is described with the following items 1) to 6). In the following, PA refers to an amplifying device. 1) initially, at least one PA is active and the DPD unit 1303 is properly adapted. This PA has a limited peak power capability. Due to this, it is advantageous that the CFR unit 1302 limits the peak power of the input signal accordingly to this peak power capability. 2) According to the peak power preview, an increase of the available peak power capability is required to serve a future requested peak power. 3) One or more additional PAs are activated by the PA activation signal, thus providing an increased peak power capability before the higher peak power will be required. 4) Usually, the PA properties (e.g. gain and phase response) of the active PAs will change. Those changes are time-variant and are caused by the DC bias voltage change during activation of the additional PA. The DPD unit 1303 gets the information when those changes will occur due to the knowledge of the PA activation signal. Provided with this information, the DPD unit 1303 shall compensate the PA nonlinearities including the time-variant PA property changes of the group of the active PAs. 5) Already before the peak power increase occurs, the RF signal is distributed (split) between all active PAs according to the following criteria: acceptable bandwidth expansion, tolerable EVM and minimum power consumption of the PAs. 6) The RF signal with a higher peak power can be amplified by the active (at least two) PAs, which provide a sufficiently high peak power capability.

To illustrate the function of the signal splitting in FIG. 13, lowering the peak power capability can be described the following items 1) to 5). 1) initially, at least two PAs are active and the DPD unit 1303 is properly adapted. The RF output power is low enough to allow for a de-activation (switch-off) of at least one PA and still providing a sufficiently high peak power capability. 2) Before any PA is de-activated, the RF signal is re-distributed between the PAs which shall remain active, whereas no RF signal is further provided to the PAs being foreseen for de-activation. The clipping parameters are re-adjusted to avoid that the RF signal exceeds the peak power capability which is associated with the targeted PA de-activation. 3) The targeted PA deactivation shall be triggered by the PA activation signal. 4) Usually, the PA properties (e.g. gain and phase response) of the active PAs will change. Those changes are time-variant and are caused by the DC bias voltage change during PA deactivation. The DPD unit 1303 gets the information when those changes will occur due to the knowledge of the PA activation signal. 5) The DPD unit 1303 shall compensate the PA nonlinearities including the time-variant PA property changes of the group of the active PAs.

The DPD unit 1303 may permanently monitor, using a DPD RX, the RF output of the power amplification system 1301 for an adaptation of its internal parameters.

**FIG. 14** illustrates a method for transition between activation states of a power amplification system in accordance with an example of the present subject matter.

FIG. 14 illustrates the transition options between four activation states Activation state 0, Activation state 1, Activation state 2 and Activation state 3 of a power amplification system that comprises two amplifying devices of different sizes. The smaller amplifying device is represented by an array of three array cells representing three transistor cells. The larger amplifying device is represented by an array of six array cells representing six transistor cells.

Activation state 0 has both amplifying devices inactive. Activation state 1 has only the smaller amplifying device active, whereas activation state 2 has only the larger amplifying device active and activation state 3 has both amplifying devices active.

The white array cells indicate transistor cells which are active at any (even at zero) RF input signal amplitude. The black array cells indicate transistor cells, which are totally inactive at any (even at the highest possible) RF input signal amplitude. For each possible transition, the current and the targeted activation state are known. Before any transition during which transistor cells are activated, a different "warm-up" state may occur. Since the warming up still happens within the period of lower RF input signal amplitude, the activation state virtually does not change, when the DC bias of inactive transistor cells is increased to a value at which the DC bias together with the lower RF input signal amplitude does not exceed the threshold voltage. If for example, the threshold voltage is -3.0V and the RF input signal amplitude may reach up to 4V, the transistor cells are completely deactivated at a DC bias of -7.5V (-3-4-0.5 V, including 0.5V margin). If however, the lower RF input signal amplitude prior to the activation is always below just 2V, the transistor cells may still be inactive at a "warm-up" DC bias of up to (-3-2) = -5V. For a complete activation (class AB), the DC bias may go a bit above the threshold value, for example -2.6V. Depending on the lower RF input signal amplitude prior to the activation, different "warm-up" DC bias levels are possible: The array cells with dashed lines indicate the highest "warm-up" level, which is applied before transitions from activation state 0. The array cells with dots indicate a somewhat lower "warm-up" level, which is applied before transitions from activation state 1 to activation state 3. Note that no or just a little warm-up may be applied before a transition from activation state 2 to activation state 3 as illustrated by the shaded intermediate state, which may be identical with activation state 2. In one example, there are no direct transitions between activation states 1 and 2 to avoid the risk of a (very short) deactivation of all amplifying devices. Instead, the path via activation state 3 may be followed in both directions.

As will be appreciated by one skilled in the art, aspects of the present invention may be embodied as an apparatus, method, computer program or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon. A computer program comprises the computer executable code or "program instructions".

Any combination of one or more computer readable medium(s) may be utilized. The computer readable medium may be a computer readable storage medium. A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device.

'Computer memory' or 'memory' is an example of a computer-readable storage medium. Computer memory is any memory which is directly accessible to a processor. 'Computer storage' or 'storage' is a further example of a computer-readable storage medium. Computer storage is any non-volatile computer-readable storage medium. In some embodiments computer storage may also be computer memory or vice versa.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances the computer executable code may be in the form of a high level language or in a pre-compiled form and be used in conjunction with an interpreter which generates the machine executable instructions on the fly.

Generally, the program instructions can be executed on one processor or on several processors. In the case of multiple processors, they can be distributed over several different entities. Each processor could execute a portion of the instructions intended for that entity. Thus, when referring to a system or process involving multiple entities, the computer program or program instructions are understood to be adapted to be executed by a processor associated or related to the respective entity.

## Claims

1. A power amplification system for amplification of radio frequency (RF) signals, the power amplification system comprising an amplifying unit, the amplifying unit being divided into two or more amplifying devices, wherein each amplifying device comprises transistor cells, wherein each transistor cell comprises a gate finger, wherein the gate fingers of each amplifying device are connected to at least one RF coupling network and have a separate gate bias specific to the amplifying device, wherein the RF coupling networks are connected to a common input terminal, wherein the transistor cells of the amplifying devices are connected to a set of one or more drain terminals, where each amplifying device of the amplifying devices is configured to receive a corresponding radio frequency signal from the common input terminal and to output an RF output signal.

2. The power amplification system of claim 1, the set of one or more drain terminals comprising multiple drain terminals such that the transistor cells of each amplifying device are connected to a corresponding drain terminal of the multiple drain terminals.

3. The power amplification system of claim 1 or 2, wherein the transistor cells of each amplifying device are adjacent cells.

4. The power amplification system of claim 1 or 2, wherein at least part of the transistor cells of each amplifying device are non-adjacent cells.

5. The power amplification system of any of the preceding claims, further comprising an RF combination and/or a matching network for directly combining the RF output signals from all amplifying devices that outputted the RF output signals.

6. The power amplification system of any of the preceding claims, wherein each amplifying device has an activation status which is defined by the gate bias of the amplifying device, wherein the activation status indicates that the amplifying device is activated and thus has an active status, or de-activated and thus has an inactive status.

7. The power amplification system of claim 6, wherein a set of gate biases is provided, wherein the set of gate biases comprises a gate bias, referred to as activation gate bias, which may enable to activate the associated amplifying device and other gate biases, referred to as deactivation gate biases, which may enable to deactivate the associated amplifying devices, wherein each deactivation gate bias is associated with a transition time for switching between said deactivation gate bias and the activation gate bias, wherein the power amplification system is provided such that the gate bias of each amplification device that defines the inactive status of the amplifying device is associated with a specific transition time.

8. An apparatus for amplifying a radio frequency (RF) signal using a power amplification system comprising multiple amplifying devices, the apparatus comprising means for:
determining a configuration of the power amplification system based on power values related to the RF signal, wherein the determined configuration indicates an activation-deactivation pattern of the amplifying devices of the power amplification system for amplification of the RF signal;
controlling the power amplification system according to the determined configuration for amplifying the RF signal, wherein the RF signal is derived from a respective baseband signal, wherein the configuration is determined using the baseband signal by a Crest Factor Reduction (CFR) unit of a radio unit which comprises the power amplification system.

9. The apparatus of claim 8, the activation-deactivation pattern indicating for respective ones of the amplifying devices of the power amplification system one or more activation periods and/or one or more deactivation periods of the amplifying devices during a time covered by the RF signal.

10. The apparatus of any of the preceding claims 8 to 9, wherein the apparatus further comprising means for controlling of the power amplification system according to the determined configuration by at least:
activating or de-activating each amplifying device of the power amplification system according to the activation-deactivation pattern by applying a control signal to the amplifying device, wherein the RF signal is amplified by the activated amplifying devices.

11. The apparatus of claim 10, wherein applying the control signal to activate the amplifying device comprises setting a DC bias of the amplifying device so that an RF signal that is input to the amplifying device can be amplified, wherein applying the control signal to deactivate the amplifying device comprises setting the DC bias of the amplifying device so that an RF signal that is input to the amplifying device is blocked from amplification.

12. The apparatus of any of the preceding claims 8 to 11, wherein the power amplification system is a power amplification system of any of the claims 1 to 7.

13. The apparatus of any of the preceding claims 8 to 12, wherein the apparatus further comprising means for determining of the configuration by at least:
determining, along a time domain, one or more parts of the RF signal, wherein each part has a power property that corresponds with a specific peak power capability of one or more of the amplifying devices which is different from a specific peak power capability of the amplifying devices associated with a preceding part of the RF signal and/or a following part of the RF signal;
wherein the activation-deactivation pattern indicates for each part of the RF signal that, during a time period that the part covers, an activation of the corresponding one or more amplifying devices is to be performed in order to amplify that part of the RF signal and a deactivation of non-corresponding amplifying devices is to be performed.

14. The apparatus of any of the preceding claims 8 to 12, wherein the apparatus further comprising means for controlling the power amplification system according to the determined configuration for amplifying the RF signal, by at least:
splitting a baseband signal associated with the RF signal such that the RF signal comprises one individual RF signal per subset of one or more active amplifying devices of the power amplification system according to the determined configuration, wherein the individual RF signals differ in phase, amplitude, or any combination thereof;
inputting the individual RF signals to the respective subsets of amplifying devices;
combining RF output signals from the subsets of amplifying devices for obtaining the amplified RF signal.

15. A method for amplifying a radio frequency (RF) signal in a power amplification system comprising multiple amplifying devices, the method comprising:
determining a configuration of the power amplification system based on power values related to the RF signal, wherein the determined configuration indicates an activation-deactivation pattern of the amplifying devices of the power amplification system for amplification of the RF signal;
controlling the power amplification system according to the determined configuration for amplifying the RF signal, wherein the RF signal is derived from a respective baseband signal, wherein the configuration is determined using the baseband signal by a Crest Factor Reduction (CFR) unit of a radio unit which comprises the power amplification system.
